Europäisches Patentamt

European Patent Office

Office européen des brevets

(19)

(11) EP 0 859 284 A1

(12) EUROPEAN PATENT APPLICATION

(43) Date of publication:
19.08.1998 Bulletin 1998/34

(51) Int Cl.⁶: G03F 7/038

(21) Application number: 98400325.1

(22) Date of filing: 12.02.1998

(84) Designated Contracting States:
AT BE CH DE DK ES FI FR GB GR IE IT LI LU MC
NL PT SE
Designated Extension States:
AL LT LV MK RO SI

(30) Priority: 12.02.1997 JP 44589/97

(71) Applicant: Nippon Paint Co., Ltd.
Osaka-shi, Osaka 531-0077 (JP)

(72) Inventors:
• Ueda, Eiji
  Sakai-shi, Osaka 599-8261 (JP)

• Ishii, Keizo
  Neyagawa-shi, Osaka 572-0028 (JP)
• Muramoto, Hisaichi
  Kobe-shi, Hyogo 651-1202 (JP)
• Kanoi, Yutaka
  Suita-shi, Osaka 565-0802 (JP)

(74) Representative: Hubert, Philippe et al
Cabinet Beau de Loménie
158, rue de l'Université
75340 Paris Cédex 07 (FR)

(54) Water-developable photosensitive composition and production process thereof

(57) The present invention provides a water-developable photosensitive composition capable of providing a flexographic printing plate with a satisfactory shelf life, excellent water developability, water resistance, ink resistance and aging resistance, as well as an adequate impact resilience necessary for a high evenness of the reproduced image, and a production process thereof.

A water-developable photosensitive composition comprising (A) a thermoplastic elastic polymer, (B) an ionic group- and photopolymerizable double bond-containing hydrophilic polymer, (C) a crosslinking particulate resin having an ionic group capable of forming an ion pair with said polymer (B), and (D) a photopolymerization initiator.

**Description**

TECHNICAL FIELD

The present invention relates to a water-developable photosensitive composition for use as a flexographic printing plate and to a process for the production of the composition.

BACKGROUND ART

The flexographic printing plate is obtained from a photosensitive resin composition. The plate is manufactured into a printing by exposing such a plate through a pattern superimposed thereon to ultraviolet radiation and dissolving off the uncured part with a solvent. As the photosensitive resin composition for use in such a flexographic printing plate, a variety of compositions have been employed which can be developed with an organic solvent. In recent years, however, photosensitive resin compositions have been proposed which is capable of developing with water, in view of the possible hazards to health and environment, such as toxicity and the risk of ignition. In addition, regarding the ink for use in flexographic printing, water-based inks have come to be used from the same safety considerations.

Japanese Kokai Publications Sho-52-134655, Sho-53-10648 and Sho-61-22339 disclose photosensitive resin compositions each comprising a copolymer obtained from a conjugated diene hydrocarbon and an α, β - ethylenically unsaturated carboxylic acid or a salt thereof and optionally containing a monoolefinically unsaturated compound, a photopolymerizable unsaturated monomer and a photosensitizer. Those technologies enable image development with a developer such as an aqueous alkali solution or an aqueous alkali solution-organic solvent but hardly enable development with the so-called tap water at a pH of from 5.0 to 9.0.

Japanese Kokai Publication Sho-60-211451 discloses a photosensitive elastomer composition comprising a copolymer of a conjugated diene hydrocarbon polymer or a conjugated diene hydrocarbon with a monoolefinically unsaturated compound, a hydrophilic macromolecular compound, a nongaseous ethylenically unsaturated compound and a photopolymerization initiator. Japanese Kokai Publication Sho-60-173055 discloses a photosensitive resin composition comprising an α, β -ethylenic unsaturation-containing hydropholic oligomer, an elastomeric water-swellable substance and a photopolymerization initiator.

Those technologies provide for satisfactory water-developability because of the increased content of a hydrophilic component that is amenable to development with a water-based developer. Just because of this high content of a hydrophilic component, however, the proportion of a thermoplastic elastomer necessary for imparting resilience is drastically decreased as compared with the conventional flexographic printing plate designed for development with an organic solvent developer. As a result, the resilience of the plate is insufficient, thus causing unevenness of the reproduced image and a failure to insure satisfactory printing results.

Japanese Kokai Publication Hei-5-178946 discloses a photosensitive resin composition comprising microgel particles of an ethylenically unsaturated compound, a photosensitive microgel and an ethylenically unsaturated compound. Japanese Kokai Publication Hei-7-114180 discloses a photosensitive composition comprising a phosphorus-containing hydrophilic copolymer, a thermoplastic elastomer, an ethylenically unsaturated monomer and a photopolymerization initiator. Japanese Kokai Publication Hei-7-178946 discloses a photosensitive resin composition comprising a microgel binder, an ethylenically unsaturated monomer, a photopolymerization initiator and a neutralizer.

However, those technologies invariably use a nongaseous ethylenically unsaturated compound as an essential component so that the resulting resin compositions are inadequate in shelf life and the aging resistance of the flexographic printing plate obtained is not sufficiently high, either. Moreover, mechanical strength such as resilience and wear on printing and other phisical properties of the flexographic printing plate are deteriorated owing to residues of the unreacted nongaseous ethylenically unsaturated compound. In addition, the ink resistance thereof is decreased to cause swelling of the plate by ink during printing.

Japanese Kokai Publication Hei-8-160618 discloses a photosensitive resin composition comprising a conjugated diene hydrocarbon, a crosslinkable particulate substance or a hydrophilic macromolecular compound, a nongaseous ethylenically unsaturated compound and a photopolymerization initiator. According to this technology, the photosensitive resin composition assumes such a phase structure wherein a hydrophilic phase surrounds a hydrophobic phase, with the consequent improvements in the conflicting properties of water developability and ink resistance.

However, this technology uses a nongaseous ethylenically unsaturated compound as an essential component as in the technologies mentioned above, so that both the shelf life of the composition and the aging resistance of the flexographic printing plate are inadequate. Furthermore, since the phase structure can hardly be controlled, the degree of freedom in plate design is small and it is difficult to provide the phase structure necessary for improvements in water developability and ink resistance with good reproducibility.

As has been pointed out above, the flexographic printing plate is required to have impact resilience, water developability, water resistance, and ink resistance, among other properties. In order to improve impact resilience, however, the proportion of the hydrophilic component must be decreased. This results in poor water developability. On the other hand, increasing the proportion of the hydrophilic component for improving water developability results in a failure to provide sufficient impact resilience. Moreover, while water resistance and ink resistance can be improved by reducing the proportion of the hydrophilic component, improving those properties result in poor water developability. Therefore, it has been extremely difficult to design a photosensitive resin composition capable of providing a flexographic printing plate having all the above-mentioned necessary properties in a steady manner unless a drastic departure is made from the conventional formulations.

In view of the above state of the art, the present invention has for its object to provide a water-developable photosensitive composition capable of providing a flexographic printing plate with a satisfactory shelf life, excellent water developability. water resistance, ink resistance and aging resistance, as well as an adequate impact resilience necessary for a high evenness of the reproduced image, and a preparation process thereof.

## SUMMARY OF THE INVENTION

The present invention relates to a water-developable photosensitive composition comprising (A) a thermoplastic elastic polymer, (B) an ionic group- and photopolymerizable double bond-containing hydrophilic polymer, (C) a crosslinking particulate resin having an ionic group capable of forming an ion pair with said polymer (B), and (D) a photopolymerization initiator.

The present invention further relates to a process for producing the above water-developable photosensitive composition, which comprises dispersing, in a solvent, (B) an ionic group- and photopolymerizable double bond-containing hydrophilic polymer, (C) a crosslinking particulate resin having an ionic group capable of forming an ion pair with said polymer (B), and (D) a photopolymerization initiator, adding and dispersing (A) a thermoplastic elastic polymer therein, and then removing said solvent.

## BRIEF DESCRIPTION OF THE DRAWINGS

Fig. 1 is a schematic view showing the construction of the water-developable photosensitive composition obtained in Example 1.

Fig. 2 is a schematic view showing the construction of the water-developable photosensitive composition obtained in Comparative Example 1.

## DETAILED DESCRIPTION OF THE INVENTION

The present invention is now described in detail.

The water-developable photosensitive composition of the present invention comprises (A) a thermoplastic elastic polymer, (B) an ionic group- and photopolymerizable double bond-containing hydrophilic polymer, (C) a crosslinking particulate resin having an ionic group capable of forming an ion pair with said polymer (B), and (D) a photopolymerization initiator.

Said thermoplastic elastic polymer (A) is not particularly limited in kind. Thus, a suitable compound can be adequately selected according to the intended application of the water-developable photosensitive composition. However, it is preferably a triblock copolymer having a hard segment/soft segment/hard segment structure.

This triblock copolymer having a hard segment/soft segment/hard segment structure is now described in detail.

Said hard segment is a thermoplastic nonelastomeric polymer with a glass transition temperature (Tg) of not lower than 40°C, preferably not lower than 60°C. Said soft segment is an aliphatic conjugated diene elastomeric polymer with a glass transition temperature (Tg) of not higher than 20°C, preferably not higher than 0°C.

Said thermoplastic nonelastomeric polymer is preferably prepared from an aromatic vinyl monomer. This aromatic vinyl monomer is not particularly restricted in kind but includes styrene, α-methylstyrene, p-methylstyrene, p-t-butylstyrene, N,N-dimethyl-p-aminostyrene, N,N-diethyl-p-aminostyrene, 1,1-diphenylstyrene, divinylbenzene, and vinylpyridine, among other monomers. Those monomers can be used alone or in combination. Particularly preferred is styrene.

The thermoplastic nonelastomeric polymer may, if necessary, be a copolymer of said aromatic vinyl monomer with at least one monomer selected from the group consisting of aliphatic diene monomers and functional monomers. In such cases, the proportion of said aromatic vinyl monomer is preferably not less than 45 % by weight based on the total weight of the thermoplastic nonelastomeric polymer. If it is smaller than 45 % by weight, the glass transition temperature (Tg) of the polymer may fall below 40°C, thus giving an elastomer which is unsuited for the present invention.

Said aliphatic diene monomer is not particularly restricted in kind, either, but includes butadiene, isoprene, 1,3-pentadiene, 1,3-hexadiene, 2,3-dimethylbutadiene, 2-methyl-1,3-pentadiene, 4,5-diethyl-1,3-octadiene, 3-butyl-1,3-octadiene, chloroprene, etc. Those monomers can be used alone or in combination. Particularly preferred are butadiene and isoprene.

Said functional monomer is not restricted in kind but includes (meth)acrylic acid and 2-hydroxyethyl (meth)acrylate, among others.

The above copolymer of the aromatic vinyl monomer with at least one monomer selected from the group consisting of aliphatic diene monomers and functional monomers may be a random copolymer or a tapered block copolymer. This tapered block copolymer is such that the amount of the aromatic vinyl monomer is progressively increased toward the terminal end of the polymer.

There is no particular limitation on the method for providing said random copolymer. This can be obtained, for example, by adding the respective monomers in small portions at a constant rate to the reaction system. In addition, this can be also obtained by carrying out the polymerization in the presence of a randomizing agent.

The method for forming said tapered block copolymer is not restricted. A typical method comprises polymerizing all the monomers without addition of a randomizing agent in an effective amount.

Said aliphatic conjugated diene elastomeric polymer, which constitutes said soft segment, is predominantly composed of an aliphatic conjugated diene monomer. This aliphatic conjugated diene monomer is not particularly restricted in kind but includes the species of the aliphatic diene monomer mentioned hereinbefore, for instance. Those monomers can be used alone or in combination. Particularly, butadiene, isoprene, 1,3-pentadiene and 2,3-methylbutadiene can be mentioned as preferred species because they are capable of providing said thermoplastic elastic polymer (A) with superior physical properties and ease for industrial use. Particularly preferred are butadiene and isoprene.

The aliphatic conjugated diene elastomeric polymer may, if necessary, be a random copolymer with an aromatic vinyl monomer. This aromatic vinyl monomer is not particularly restricted in kind but includes those species mentioned hereinbefore. In copolymerizing said aliphatic conjugated diene monomer with said aromatic vinyl monomer, the proportion of said aromatic vinyl monomer is preferably less than 35 % by weight based on the total weight of said aliphatic conjugated diene elastomeric polymer. If it is larger than 35 % by weight, the glass transition temperature (Tg) of the polemer may exceed 20°C, thus depriving the polymer of elastomeric properties.

The proportion of said soft segment is preferably from 50 to 95 % by weight based on the total weight of said triblock copolymer. If it is smaller than 50 % by weight, the copolymer may be too hard for the production of flexographic printing plates. On the other hand, if it exceeds 95% by weight, the polymer may not sufficiently express the required rubber-like properties, namely low hardness and high impact resilience, and mechanical strength.

Said triblock copolymer can be produced typically by the so-called living anion polymerization process which comprises polymerizing an aromatic vinyl monomer as said hard segment with an aliphatic conjugated diene monomer as said soft segment in the presence of an organolithium catalyst. As disclosed in the specifications of US Patents No. 3317918 and 3660563, this living anion polymerization process is carried out in a hydrocarbon solvent using an organolithium catalyst at a temperature of generally from -30°C to -150°C, preferably from 15°C to 130°C. The hydrocarbon solvent can include pentane, hexane, heptane cyclohexane and so on. The organolithium catalyst can include n-butyllithium, sec-butyllithium, dilithium butane or the like. The polymerization temperature may be constant or may be allowed to rise without cooling. The number average molecular weight (Mn) of the thermoplastic elastic polymer (A) produced by the above living anion polymerization process can be controlled by adjusting the proportion of said organolithium catalyst.

In this living anion polymerization process, a coupling agent can be added in a given amount to the reaction system on the condition where the active lithium species is present at the polymer chain terminus, as described in Japanese Kokoku Publications Sho-59-36949 and Sho-57-49049. Thus, it is possible to couple two or more, for example 2 to 4, polymer chains. The coupling agent used is not particularly restricted in kind but includes diethyl adipate, divinylbenzene, tetrachlorosilane, butyltrichlorosilane, tetrachlorotin, butyltrichlorotin, dimethyldichlorosilane, tetrachlorogermanium, 1,2-dibromoethane, 1,4-di(chloromethyl)benzene, bis(trichlorosilyl)ethane, epoxidized linseed oil, tolylene diisocyanate, and 1,2,4-benzene triisocyanate, among others.

The number average molecular weight of said triblock copolymer is preferably from 10,000 to 1,000,000. If it is less than 10,000, the polymer may not attain the adequate physical properties and mechanical characteristics necessary for the intended application. Conversely, if it exceeds 1,000,000, the solution viscosity may be too high to uniformly disperse it in a solvent. The still more preferred number average molecular weight is from 50,000 to 500,000.

The above triblock copolymer may be hydrogenated in the conjugated diene moiety contained in said soft segment. This hydrogenation can be carried out typically by dissolving the triblock copolymer in an inert solvent and hydrogenating it in the presence of a hydrogenation catalyst, for example, in a hydrogen atmosphere at a pressure of from 1 to 100 kg/cm$^2$ and a temperature of from 20 to 150°C, as described in Japanese Kokoku Publications Sho-63-4841 and Sho-63-5401.

Said inert solvent is not particularly restricted in kind but includes hydrocarbon solvents such as hexane, heptane, cyclohexane, benzene, toluene, ethylbenzene, etc.; and polar solvents such as methyl ethyl ketone, ethyl acetate, diethyl ether, tetrahydrofuran, etc.

Said hydrogenation catalyst is not particularly restricted in kind but includes dicyclopenta-diethinyltitanium halides;

nickel organic carboxylates; the systems consisting of a nickel organic carboxylate and an organometal compound the metals of which is belonged to Groups I to III of Periodic Table of the Elements; supported metal catalysts such as nickel, platinum, palladium, ruthenium, rhenium or rhodium, as supported on a carrier such as carbon, silica or diatomaceous earth; supported complex compounds of metals such as cobalt, nickel, rhodium or ruthenium, as supported on a carrier such as carbon, silica or diatomaceous earth; lithium aluminum hydride; p-toluenesulfonylhydrazide; Zr-Ti-Fe-V-Cr alloy; Zr-Ti-Nb-Fe-V-Cr alloy; and hydrogen storage alloys such as $LaNi_5$ alloy.

The degree of hydrogenation can be controlled by adjusting the proportion of said hydrogenation catalyst, initial hydrogen pressure and reaction time. In the present invention, the preferred percentage of residual carbon-carbon double bonds in the aliphatic conjugated diene units is not higher than 30 mole %. If it exceeds 30 mole %, heat resistance, weather resistance and ozone resistance may become insufficient for certain applications of the water-developable photosensitive composition. The more preferred percentage is not higher than 20 mole % and the particularly preferred percentage is not higher than 10 mole %.

The triblock copolymer thus hydrogenated is isolated from the solvent after removal of the hydrogenation catalyst and addition of a phenol or amine type aging inhibitor. This isolation can be effected typically by adding a solvent such as acetone or an alcohol into the reaction mixture so as to precipitate the hydrogenated triblock copolymer, or by pouring the reaction mixture in hot water under constant stirring and removing the solvent.

The preferred number average molecular weight (Mn) of said hydrogenated triblock copolymer is generally between 40,000 and 700,000. If it is less than 40,000, the postcure strength and heat resistance of the water-developable photosensitive composition tends to be deteriorated. If it exceeds 700,000, the fluidity and processability of the water-developable photosensitive composition may be decreased and/or the molded appearance tends to be sacrificed. The still more preferred range is from 50,000 to 500,000.

As said hydrogenated triblock copolymer, commercial products can be utilized. For example, Cepton (Kuraray) and Dynalon (Japan Synthetic Rubber Co., Ltd.) can be employed.

As the above thermoplastic elastic polymer (A), too, commercial products can be utilized. For example, there can be mentioned Tapflene (Asahi Chemical Industry Co., Ltd.), Soltoprene (Japan Elastomer), JSR-DR (Japan Synthetic Rubber), Elastomer AR (Aron Kasei Co., Ltd.), Sumitomo TPE-SP (Sumitomo Chemical Company), Europrene SOL T (Tosoh Corporation), and KRATON D and KRATON G Series (both available from Shell Chemical), among others.

The thermoplastic elastic polymer (A) may contain at least one kind of functional group selected from the group consisting of carboxyl, hydroxy, amino and epoxy. The presence of such functional groups leads to further improvements in the water developability of the water-developable photosensitive composition.

Introduction of said functional groups into the thermoplastic elastic polymer (A) can be effected typically by the following two methods:

Copolymerizing an aromatic vinyl monomer and/or an aliphatic conjugated diene monomer with a monomer containing at least one kind of said functional group (disclosed by Japanese Kokai Publications Hei-6-27664 and Hei-6-41256, etc); and

Grafting a reactive compound containing at least one kind of said functional group to a prepared thermoplastic elastic polymer (disclosed by Japanese Kokoku Publications Sho-60-49203 and Hei-03-66326, etc.). Among them, the grafting method is more practical and preferred because the characteristics of the water-developable photosensitive composition can be easily controlled over a broad range.

There is no particular limitation on said monomer containing at least one kind of the functional group. Thus, for example, there can be mentioned carboxyl-containing compounds such as acrylic acid, methacrylic acid, maleic anhydride or maleic acid; hydroxyl-containing compounds such as 2-hydroxyethyl (meth)acrylate, 2-hydroxypropyl (meth)acrylate or 3-hydroxypropyl (meth)acrylate; amino-containing compounds such as 2-dimethylaminoethyl (meth)acrylate, 2-diethylaminoethyl (meth)acrylate, 2-dimethylaminopropyl (meth)acrylate or 3-dimethylaminopropyl (meth)acrylate; and epoxy-containing compounds such as glycidyl (meth)acrylate.

The preferred introduction ratio of said functional groups is generally not greater than 40 mole % based on the total number of repeating units of said thermoplastic elastic polymer (A). The still more preferred ratio is from 0.1 to 30 mole %.

The proportion of said thermoplastic elastic polymer (A) can be adequately selected according to the intended application of the water-developable photosensitive composition. However, it is preferably from 40 to 90 % by weight based on the total solid content of the water-developable photosensitive composition. If it is smaller than 40 % by weight, the flexographic printing plate formed from the water-developable photosensitive composition may be insufficient in impact resilience. In addition, the characteristics of components other than the thermoplastic elastic polymer (A) may be expressed too prominently. On the other hand, if the proportion exceeds 90 % by weight, the hydrophilic component may be proportionally too small to insure a sufficient level of water developability and the polymer (A) may not be well dispersed in the hydrophilic component. The still more preferred range is from 50 to 80 % by weight.

The ionic group- and photopolymerizable double bond-containing hydrophilic polymer (B) according to the present invention is not particularly restricted in kind. However, it includes those polymers whose skeletal structure is composed of a polymer formed from a polymerizable monomer and which have an ionic group and a photopolymerizable double bond.

Said polymerizable monomer includes but is not limited to hydroxyl-containing monomers such as 2-hydroxyethyl acrylate, 2-hydroxyethyl methacrylate, hydroxypropyl acrylate, hydroxypropyl methacrylate, hydroxybutyl acrylate, hydroxybutyl methacrylate, allyl alcohol, methallyl alcohol, ethylene glycol mono(meth)acrylate, ethylene glycol monoalkyl ether mono(meth)acrylate, diethylene glycol mono(meth)-acrylate, diethylene glycol monoalkyl ether mono(meth)acrylate, triethylene glycol mono(meth)-acrylate, diethylene glycol monoalkyl ether mono-(meth)acrylate, polyethylene glycol mono(meth)acrylate with a molecular weight of from 200 to 1,000 or polyethylene glycol monoalkyl ether mono (meth)acrylate with a molecular weight of from 200 to 1,000; and vinyl monomers such as methyl acrylate, methyl methacrylate, ethyl acrylate, ethyl methacrylate, n-butyl acrylate, n-butyl methacrylate, isobutyl acrylate, 2-ethylhexyl acrylate, lauryl methacrylate, phenyl acrylate, styrene, $\alpha$-methylstyrene, vinyl ketones, t-butylstyrene, p-chlorostyrene or vinylnaphthalene. Those momomers can be used alone or in combination.

There is no particular limitation on the technology for polymerizing said polymerizable monomers. Thus, for example, addition polymerization, polycondensation, ring-opening polymerization, etc. can be mentioned. While the polymerization method is adequately selected according to the type of polymerizable monomer used, it is generally advantageous to use the addition polymerization.

The water-developable photosensitive composition can be provided with the desired postcure characteristics by selecting the proper types and/or combination of said polymerizable monomers in the hydrophilic polymer (B),.

The hydrophilic polymer (B) is a polymer having at least one kind of ionic group capable of forming an ion pair with the crosslinking particulate resin (C), which will be described in detail hereinafter. The ionic group includes but is not limited to carboxyl, phosphate, sulfo, amino and imino.

The method for introduction of the ionic group is not particularly restricted. Thus, this introduction can be effected, for example, by the following three methods:

(1) Copolymerizing an ionic goup-containing polymerizable unsaturated monomer with said polymerizable monomer;
(2) Modifying a polymer prepared from said polymerizable monomer beforehand so as to introduce said ionic group; and
(3) Using an ionic group-containing initiator in the polymerization.

Referring to the above method (1) for copolymerizing an ionic group-containing polymerizable unsaturated monomer with said polymerizable monomer, the ionic group-containing polymerizable unsaturated monomer is not particularly restricted in kind. It includes carboxyl-containing monomers such as acrylic acid, methacrylic acid, crotonic acid, itaconic acid, maleic acid or fumaric acid; amino-containing alkyl (meth)acrylates such as dimethylaminoethyl acrylate, dimethylaminoethyl methacrylate, dimethylaminopropyl acrylate, dimethylaminopropyl methacrylate or dimethylaminopropyl (meth)acrylamide; sulfo-containing monomers such as vinylsulfonic acid; phosphate-containing monomers such as mono[2-(meth)acryloyloxyethyl] acid phosphate or 3-chloro-2-acid phosphoxypropyl (meth)acrylate.

In the above method (2) for modifying a polymer prepared from said polymerizable monomer beforehand, the modification can be effected by adding a cyclic acid anhydride such as maleic anhydride, fumaric anhydride or itaconic anhydride to the reaction system for said polymer synthesis and causing the anhydride to undergo ring-opening reaction to introduce the desired ionic group.

Referring to the above method (3) for using an ionic group-containing initiator in the polymerization, there is no particular limitation on the kind of initiator. Typical examples are imino-containing initiators such as 2,2'-azobis[2-(2-imidazolin-2-yl)propane] (VA-061, Wako Pure Chemical Industries) or 2,2'-azobis[2-(3,4,5,6-tetrahydropyrimidin-2-yl)propane] dihydrochloride (VA-058, Wako Pure Chemical Industries).

The above hydrophilic polymer (B) further contains a photopolymerizable double bond. This photopolymerizable double bond undergoes polymerization upon exposure to light in the presence of a photopolymerization initiator (D), which will be described in detail hereinafter. The photopolymerizable double bond can be introduced by using a photopolymerizable monomer.

This photopolymerizable monomer is not particularly restricted in kind but includes the following monomers, among others.

Thus, aromatic vinyl monomers such as styrene, $\alpha$-methylstyrene, o-methylstyrene, m-methylstyrene, p-methylstyrene, p-t-butylstyrene, o-methoxystyrene, m-methoxystyrene, p-methoxystyrene, o-chlorostyrene, m-chlorostyrene, p-chlorostyrene, 1,1-diphenyl-ethylene, divinylbenzene, diisopropenylbenzene, etc.; hydroxyl-containing aromatic vinyl monomers such as o-hydroxystyrene, o-hydroxy-$\alpha$-methylstyrene, p-hydroxy-$\alpha$-methylstyrene, p-vinylbenzyl alcohol, etc.; unsaturated nitriles such as (meth)acrylonitrile, $\alpha$-chloroacrylonitrile, $\alpha$-chloromethylacrylonitrile, $\alpha$-meth-

oxyacrylonitrile, α -ethoxyacrylonitrile, crotononitrile, cinnamonitrile, itacononitrile, maleonitrile, fumaronitrile, etc.; alkyl (meth)acrylates such as methyl (meth)acrylate, ethyl (meth)acrylate, n-propyl (meth)acrylate, isopropyl (meth)acrylate, n-butyl (meth)acrylate, isobutyl (meth)acrylate, sec-butyl (meth)acrylate, t-butyl (meth)acrylate, n-amyl (meth)acrylate, n-octyl (meth)acrylate, 2-ethylhexyl (meth)acrylate, lauryl (meth)acrylate, stearyl (meth)acrylate, etc.; fluoroalkyl (meth) acrylates such as trifluoropropyl (meth)acrylate, heptafluorobutyl (meth)acrylate, etc.; mono- or di(meth)acrylates of alkylene glycols such as ethylene glycol, 1,2-propanediol, 1,3-propanediol, 3-chloro-1,2-propanediol, 1,2-butanediol, 1,3-butanediol, 1,4-butanediol, 1,5-pentanediol, 1,6-hexanediol, etc.; mono- or di(meth)acrylates of polyalkylene glycols such as polyethylene glycol, polypropylene glycol, etc.; mono- or poly(meth)acrylates of tri- or polyhydric alcohols such as glycerol, 1,2,4-butanetriol, trimethylolpropane, pentaerythritol, dipentaerythritol, etc.; and mono- or oligo(meth) acrylates of tri- or polyhydric alcohol-polyalkylene glycol adducts can be mentioned.

There can also be mentioned alkoxyalkyl (meth)acrylates such as 2-methoxyethyl (meth)acrylate, 2-ethoxyethyl (meth)acrylate, 2-methoxypropyl (meth)acrylate, 3-methoxypropyl (meth)acrylate, 2-ethoxypropyl (meth)acrylate, 3-ethoxypropyl (meth)acrylate, etc.; (meth)acrylates of alkoxy poly(alkylene glycols) such as methoxy poly(ethylene glycol), ethoxy poly(ethylene glycol), methoxy poly(propylene glycol), ethoxy poly(propylene glycol), etc.; aryloxyalkyl (meth)acrylates such as 2-phenoxyethyl (meth)acrylate, 2-phenoxypropyl (meth)acrylate, 3-phenoxypropyl (meth)acrylate, etc.; mono(meth)acrylates of aryloxy poly(alkylene glycols) such as phenoxy poly(ethylene glycol), phenoxy poly (propylene glycol), etc.; cyanoalkyl (meth)acrylates such as 2-cyanoethyl (meth)acrylate, 2-cyanopropyl (meth)acrylate, etc.; mono- or oligo(meth)acrylates of cyclic polyols such as 1,4-cyclohexanediol, 1,4-benzenediol, 1,4-dihydroxyethylbenzene, etc.; di(meth)acrylates of polymers having hydroxyl groups at both ends, such as hydroxy-biterminated polybutadiene, hydroxy-biterminated polyisoprene, hydroxy-biterminated butadiene-acrylonitrile copolymer, hydroxy-biterminated polycaprolactone, etc.; oligo(meth)-acrylates such as polyester resin (meth)acrylate, epoxy resin (meth) acrylate, urethane resin (meth)acrylate, alkyd resin (meth)acrylate, silicone resin (meth)acrylate, spiran resin (meth) acrylate, etc.; esters of unsaturated monocarboxylic acids other than (meth)acrylic acid, such as methyl crotonate, ethyl crotonate, propyl crotonate, butyl crotonate, hexyl crotonate, octyl crotonate, 2-ethylhexyl crotonate, 2-hydroxyethyl crotonate, 2-hydroxypropyl crotonate, propyl cinnamate, butyl cinnamate, hexyl cinnamate, octyl cinnamate, 2-ethylhexyl cinnamate, 2-hydroxyethyl cinnamate, 2-hydroxypropyl cinnamate, etc.; diesters, e.g. the dimethyl, diethyl, dipropyl, dibutyl and dihexyl esters, of unsaturated dicarboxylic acids such as maleic acid, maleic anhydride, fumaric acid, itaconic acid, itaconic anhydride, citraconic acid, mesaconic acid, etc.; dinitriles of unsaturated dicarboxylic acids; and diamides of unsaturated dicarboxylic acids.

There can also be mentioned unsaturated monocarboxylic amides such as (meth)acrylamide, N,N'-methylenebis (meth)acrylamide, N,N'-ethylene-bis(meth)acrylamide, N,N'-hexamethylenebis(meth)-acrylamide, crotonamide, cinnamamide, N-hydroxy-methyl(meth)acrylamide, N-(2-hydroxyethyl)(meth)-acrylamide, N-(2-hydroxypropyl)(meth)acrylamide, N,N-bis(2-hydroxyethyl)(meth)acrylamide, N-hydroxy-methylcrotonamide, N-(2-hydroxyethyl)crotonamide, N-(2-hydroxypropyl)crotonamide, N-hydroxymethylcinnam-amide, N-(2-hydroxyethyl)cinnamamide, N-(2-hydroxypropyl)cinnamamide, etc.; unsaturated alcohols such as (meth)allyl alcohol, ethylene glycol monovinyl ether, ethylene glycol monoallyl ether, propylene glycol monovinyl ether, propylene glycol monoallyl ether, etc.; epoxy-containing unsaturated compounds such as glycidyl (meth)acrylate allylglycidyl ether etc; vinyl chloride, vinyl acetate, dicyclopentadiene, ethylidenenorbornene, etc.

Furthermore, there can be mentioned unsaturated carboxylic acids such as (meth)acrylic acid, crotonic acid, cinnamic acid, etc.; unsaturated polycarboxylic acids (and hydrides) such as maleic acid, maleic anhydride, fumaric acid, itaconic acid, itaconic anhydride, citraconic acid, mesaconic acid, etc.; free carboxyl-containing ester compounds such as the monomethyl, monoethyl, monopropyl, monobutyl, monohexyl, monooctyl, and mono-2-ethylhexyl esters of unsaturated polycarboxylic acids such as maleic acid, maleic anhydride, fumaric acid, itaconic acid, itaconic anhydride, citraconic acid, mesaconic acid, etc. ; free-carboxyl-containing hydroxyalkyl esters such as the mono(2-hydroxyethyl) and mono(2-hydroxypropyl) esters of unsaturated polycarboxylic acids; free carboxyl-containing nitriles such as mononitriles of unsaturated polycarboxylic acids; free carboxyl-containing amides such as monoamides of unsaturated polycarboxylic acids; N-hydroxyalkyl derivatives of free carboxyl-containing amides of unsaturated polycarboxylic acids; free carboxyl-containing esters of nonpolymerizable polycarboxylic acids such as phthalic acid, succinic acid, adipic acid, etc. with hydroxy-containing unsaturated compounds such as allyl alcohol, 2-hydroxyethyl (meth)acrylate, etc.

The above-mentioned photopolymerizable monomer further includes primary amino-containing monomers such as aminomethyl (meth)acrylate, 2-aminoethyl (meth)acrylate, 2-aminopropyl (meth)acrylate, 3-aminopropyl (meth)acrylate, 2-aminoethoxyethyl (meth)acrylate, N-aminomethyl(meth)acrylamide, N-2-aminoethyl(meth)acrylamide, N-2-aminopropyl(meth)-acrylamide, N-3-aminopropyl(meth)acrylamide, o-aminostyrene, m-aminostyrene, p-aminostyrene, etc.; secondary amino-containing monomers such as methylaminomethyl (meth)acrylate, ethylaminomethyl (meth)acrylate, 2-methylaminoethyl (meth)acrylate, 2-ethylaminoethyl (meth)acrylate, 2-propylaminoethyl (meth)acrylate, 2-methylaminopropyl (meth)acrylate, 3-methylaminopropyl (meth)acrylate, 2-ethylaminopropyl (meth)acrylate, 3-ethylaminopropyl (meth)acrylate, 2-propylaminopropyl (meth)acrylate, 3-propylaminopropyl (meth)acrylate, 2-methylamino-ethoxyethyl (meth)acrylate, 2-ethylaminoethoxyethyl (meth)acrylate, N-methylaminomethyl(meth)acrylamide, N-ethylaminomethyl(meth)acrylamide, N-2-methyl-aminoethyl(meth)acrylamide, N-2-ethylaminoethyl-(meth)acrylamide, N-2-methylaminopropyl(meth)-acrylamide, N-3-methylaminopropyl(meth)acrylamide, N-methyl-o-aminostyrene, N-methyl-m-aminostyrene, N-methyl-p-aminostyrene, N-ethyl-o-aminostyrene, N-ethyl-m-aminostyrene, N-ethyl-p-aminostyrene, etc.

The photopolymerizable monomer further includes tertiary amino-containing monomers such as dimethylaminomethyl (meth)acrylate, diethylaminomethyl (meth)acrylate, 2-dimethylaminoethyl (meth)acrylate, 2-diethylaminoethyl (meth)acrylate, 2-dipropyl-aminoethyl (meth)acrylate, 2-dimethylaminopropyl (meth)acrylate, 3-dimethylaminopropyl (meth)acrylate, 2-diethylaminopropyl (meth)acrylate, 3-diethylaminopropyl (meth)acrylate, 2-dipropylaminopropyl (meth)acrylate, 3-dipropylaminopropyl (meth)acrylate, 2-dimethylaminoethoxyethyl (meth)acrylate, 2-diethylaminoethoxyethyl (meth)acrylate, N-dimethyl-aminomethyl(meth)acrylamide, N-diethylaminomethyl-(meth)acrylamide, N-2-dimethylaminoethyl(meth)-acrylamide, N-2-diethylaminoethyl(meth)acrylamide, N-2-dimethylaminopropyl(meth) acrylamide, N-3-dimethylaminopropyl(meth)acrylamide, N-2-diethyl-aminopropyl(meth)acrylamide, N-3-diethylaminopropyl(meth)acrylamide, N,N-dimethyl-p-aminostyrene, N,N-diethyl-p-aminostyrene, vinylpyridine, N,N-dimethylaminoethyl-N'-(meth)acryloyl carbamate, N,N-diethylaminoethyl-N'-(meth)acryloyl carbamate, etc.; and isocyanates such as 2-methacryloyloxyethyl isocyanate and so on. Those compounds can be used alone or in combination.

There is no particular limitation on the method for introducing the photopolymerizable double bond using the photopolymerizable monomer. Thus, this introduction can carried out, for example, by copolymerizing the polymerizable monomer with the ionic group-containing polymerizable unsaturated monomer and causing a hydroxyl or amino group contained in the resulting copolymer to react with an isocyanate compound containing a photopolymerizable double bond, such as 2-methacryloyloxyethyl isocyanate. In addition, it can also be carried out by adding a cyclic acid anhydride such as maleic anhydride, fumaric anhydride or itaconic anhydride to the reaction system for the polymer synthesis and causing it to undergo ring-opening reaction using a hydroxyl- or amino-containing photopolymerizable unsaturated monomer or the like.

In the hydrophilic polymer (B), the photopolymerizable double bond is not limited to one introduced using the photopolymerizable monomer. This introduction may be effected, for example, by copolymerizing the polymerizable monomer with the ionic group-containing polymerizable unsaturated monomer and causing the hydroxyl group contained in the resulting copolymer to undergo dehydration by condensation, for instance.

The preferred number average molecular weight (Mn) of the hydrophilic polymer (B) is from 500 to 10,000. If the Mn is less than 500, the viscosity of the resulting water-developable photosensitive composition may be too low to provide sufficient adhesion. If the upper limit of 10,000 is exceeded, the viscosity of the resulting water-developable photosensitive composition may be increased to cause poor processability in the manufacture of a flexographic printing plate. The still more preferred range is from 1,000 to 8,000.

The particle diameter of said hydrophilic polymer (B) upon dispersion in water is preferably from 50 to 500 nm. If the diameter is less than 50 nm, water resistance may be drastically reduced. If it exceeds 500 nm, the water-developable photosensitive composition may be poor in water developability. The still more preferred range is from 70 to 200 nm.

It is preferable that the hydrophilic polymer (B) is capable of being dissolved in water or self-emulsified on forming an ion pair, for imparting water developability to a photosensitive composition.

The preferred proportion of said hydrophilic polymer (B) is from 1 to 60 % by weight based on the total solid content of the final water-developable photosensitive composition. If its amount is less than 1 % by weight, the photosensitive composition may be insufficient in water developability. Conversely if it is more than 60 % by weight, the water resistance of the composition may be drastically reduced. The still more preferred range is from 3 to 50 % by weight.

The crosslinking particulate resin (C) for use in the present invention is prepared from (C1) an ethylenically unsaturated monomer and (C2) a crosslinkable monomer.

Said ethylenically unsaturated monomer (C1) is not particularly restricted in kind but includes alkyl esters of acrylic acid or methacrylic acid, such as methyl (meth)acrylate, ethyl (meth)acrylate, n-butyl (meth)acrylate, isobutyl (meth)acrylate, 2-ethylhexyl (meth)acrylate, and so forth. Those monomers can be used alone or in combination.

The ethylenically unsaturated monomer (C1) may be contain other copolymerizable monomers. Such other copolymerizing monomers are not particularly restricted in kind but includes styrene, α -methylstyrene, vinyltoluene, t-butylstyrene, ethylene, propylene, vinyl acetate, vinyl propionate, acrylonitrile, and methacrylonitrile, among other monomers. Those monomers can be used each alone or in combination.

The crosslinkable monomer (C2) comprises a monomer containing 2 or more radical-polymerizable ethylenically unsaturated bonds within the molecule and/or at least two ethylenically unsaturated monomers containing mutually reactive groups.

Said monomer containing 2 or more radical-polymerizable ethylenically unsaturated bonds within the molecule is not particularly restricted in kind but includes, for example, polymerizable unsaturated monocarboxylic esters of polyhydric alcohols, polymerizable unsaturated alcohol esters of polybasic acids, and aromatic compounds substituted by two or more vinyl groups. The following is a partial list of such monomers: ethylene glycol diacrylate, ethylene glycol dimethacrylate, triethylene glycol dimethacrylate, tetraethylene glycol dimethacrylate, 1,3-butylene glycol dimethacrylate, trimethylolpropane triacrylate, trimethylolpropane trimethacrylate, 1,4-butanediol diacrylate, neopentyl glycol diacrylate, 1,6-hexanediol diacrylate, pentaerythritol diacrylate, pentaerythritol dimethacrylate, pentaerythritol trimethacrylate, pentaerythritol tetramethacrylate, glycerol dimethacrylate, glycerol diacrylate, glycerol allyloxy dimethacrylate, 1,1,1-tris(hydroxymethyl)-ethane diacrylate, 1,1,1-tris(hydroxymethyl)ethane triacrylate, 1,1,1-tris(hydroxymethyl) ethane dimethacrylate, 1,1,1-tris(hydroxymethyl)ethane trimethacrylate, 1,1,1-tris(hydroxymethyl)propane diacrylate, 1,1,1-tris(hydroxymethyl)propane dimethacrylate, 1,1,1-tris(hydroxymethyl)propane trimethacrylate, triallyl cyanurate, triallyl isocyanurate, triallyl trimellitate, diallyl terephthalate, diallyl phthalate, and divinylbenzene, among other compounds. Those monomers can be used alone or in combination.

There is no particular limitation on the combination of said ethylenically unsaturated monomers containing mutually reactive groups. For example, the combination of an epoxy-containing ethylenically unsaturated monomer, such as glycidyl acrylate or glycidyl methacrylate, with a carboxyl-containing ethylenically unsaturated monomer, such as acrylic acid, methacrylic acid, or crotonic acid, can be mentioned. A combination of said mutually reactive groups is not limited to said epoxy-carboxyl but includes aminocarbonyl, epoxy-carboxylic anhydride, amino-carboxyl chloride, alkyleneimino-carbonyl, organoalkoxysilyl-carboxyl, and hydroxy-isocyanato, among other combinations.

The crosslinking particulate resin (C) is prepared from the ethylenically unsaturated monomer (C1) and the crosslinkable monomer (C2), supplemented with a crosslinking agent for introducing crosslinks. This crosslinking agent is not particularly restricted in kind but includes ethylene glycol dimethacrylate, diethylene glycol dimethacrylate, 1,4-butanediol dimethacrylate, and 1,6-hexanediol dimethacrylate, among others.

The preferred proportion of the crosslinking agent is from 5 to 50 % by weight based on the total weight of the crosslinking particulate resin (C). The degree of crosslinking of the crosslinking particulate resin (C) can be adjusted by varying the proportion of the crosslinking agent.

The crosslinking particulate resin (C) has a functional group capable of forming an ion pair with the hydrophilic polymer (B). This functional group is at least one kind selected from the group consisting of carboxyl, phosphate, sulfo and amino. This is adequately selected according to the kind of ionic group contained in the hydrophilic polymer (B) so that the necessary ion pair may be provided. When the crosslinking particulate resin (C) contains an acidic group such as carboxyl, a polymer having a basic group such as amino is selected for the hydrophilic polymer (B) so as to provide the necessary ion pair.

The introduction of a functional group capable of providing an ion pair can be effected, for example, by the following three methods:

(1') Copolymerizing the ethylenically unsaturated monomer (C1) and the crosslinkable monomer (C2) with (C3) a monomer having a functional group capable of providing an ion pair;
(2') Copolymerizing the ethylenically unsaturated monomer (C1) with the crosslinkable monomer (C2) and then modifying the resulting polymer to introduce an ionic group; and
(3') Using an ionic group-containing initiator in the polymerization.

In the method (1'). the monomer (C3) having a functional group is not particularly restricted in kind but includes carboxyl-containing vinyl monomers such as acrylic acid, methacrylic acid, crotonic acid, etc.; phosphate-containing vinyl monomers such as mono[2-(meth)acryloyloxyethyl] acid phosphate, 3-chloro-2-acid phosphoxypropyl (meth)acrylate, etc.; sulfo-containing vinyl monomers such as vinylsulfonic acid; and amino-containing vinyl monomers, e.g. alkyl (meth)acrylates such as dimethylaminoethyl acrylate, dimethylaminoethyl methacrylate, dimethylaminopropyl acrylate, dimethylaminopropyl methacrylate, dimethylaminopropyl(meth)acrylamide, etc. Those monomers can be used alone or in combination.

There is no particular limitation on the above method (1') for crosslinking three kinds of monomers. A suitable crosslinking method can be adequately selected according to the desired particle diameter of the product. For the production of a particulate resin with a particle diameter of from 0.01 to 0.6 μm, it can be advantageously carried out by emulsion polymerization. For the production of a particulate resin with a particle diameter of from 0.2 to 2 μm, precipitation polymerization can be employed. When the desired particle diameter is from 1 to 6 μm, suspension polymerization can be employed.

In each of the above polymerization processes, the crosslinking particulate resin (C) formed in an aqueous medium or in a non-aqueous medium can be isolated using filtration, spray drying or lyophilization. The resin thus isolated can be used either as it is or after grinding to a suitable particle diameter range using a mill or the like.

In the method (2') for copolymerizing two kinds of monomers and modifying the resulting polymer subsequently, the desired ionic group can be introduced by adding a cyclic acid anhydride, such as maleic anhydride, fumaric anhydride or itaconic anhydride, to the reaction system and then causing the anhydride group to undergo ring-opening reaction.

Referring to said method (3') for using an ionic group-containing initiator, this initiator is not particularly restricted in kind but includes those compounds mentioned hereinbefore in the description of said hydrophilic polymer (B).

Aside from the above methods, said crosslinking particulate resin (C) can also be produced by dispersing said hydrophilic polymer (B) suitably in a medium, and adding the above-mentioned monomers and/or the crosslinking agent where necessary, for subjecting the mixture to polymerization.

The crosslinking particulate resin (C) may be supplemented, if necessary, with a sensitizer useful for curing with a high-energy actinic radiation such as ultraviolet light, a promoter capable of promoting the reaction, and/or performance additives capable of providing the cured resin with improved or new functions. They can be present either on the surface of particles or within the particles.

The preferred mean particle diameter of said crosslinking particulate resin (C) is from 0.01 to 6 $\mu$m. If the diameter is less than 0.01 $\mu$m, the resin tends to give dusts to cause a hygienic problem. If the diameter is larger than 6 $\mu$m, the necessary evenness of the image may hardly be obtained in the application of the water-developable photosensitive composition as a flexographic printing plate. The still more preferred diameter is from 0.02 to 1 $\mu$m.

For use in the water-developable photosensitive composition of the present invention, said crosslinking particulate resin (C) is preferably one having a binary core-shell structure. There is no particular limitation on the method used for the formation of such a binary core-shell structure. Generally, however, this can be achieved by the so-called two-stage emulsion polymerization. This technique comprises emulsion-polymerizing said ethylenically unsaturated monomer (C1) and said crosslinkable monomers (C2) to form a core and then emulsion-polymerizing the ethylenically unsaturated monomer (C1), said copolymerizing monomers (C2) and said monomer (C3) having a functional group capable of providing an ion pair to form a shell. For the formation of an ion pair with said hydrophilic polymer (B), the above shell preferably has a mating ionic group. When the crosslinking particulate resin (C) has the above binary core-shell structure, the functional group capable of providing an ion pair can be efficiently disposed on the surface of the particulate resin.

Referring to the crosslinking particulate resin (C) having the binary core-shell structure, the ratio of the core to the shell is preferably between 5/5 and 9/1 by weight. If the weight ratio is less than 5/5, the shell layer may become too thick so that the ionic groups providing an ion pair with said hydrophilic polymer (B) may be oriented internally in the particle so that no sufficient number of ion pairs may be formed. If the ratio exceeds 9/1, the shell layer may be too thin to allow a sufficient number of ionic groups to be disposed on the surface of particles.

The particle diameter of the crosslinking particulate resin (C) having said binary core-shell structure is preferably from 30 to 100 nm. It is particularly preferable to insure that the diameter of particles resulting from solvation (hydration) by the medium (water) due to the formation of said ion pair between the hydrophilic polymer (B) and crosslinking particulate resin (C) be from 90 to 500 nm.

Referring to the crosslinking particulate resin (C), the glass transition temperature, solubility parameter, refraction index, and other properties of the very particle can be controlled by judicious choice of particle-forming components taking the relationship to other components into consideration, whereby the desired characteristics can be obtained.

The proportion of the crosslinking particulate resin (C) is preferably from 0.1 to 50 % by weight based on the total solid content of the water-developable photosensitive composition. If its proportion is smaller than 0.1 % by weight, the water developability of the composition and the post-photocure wear resistance of the printing plate may be insufficient. If 50 % by weight is exceeded, the impact resilience, hardness and other inherent characteristics required of a flexographic printing plate may be sacrificed. The still more preferred range is from 0.5 to 20 % by weight.

Referring to the hydrophilic polymer (B) and the crosslinking particulate resin (C) which are associated in the formation of an ion pair in the water-developable photosensitive composition, it is most preferable that one of them have carboxyl groups. In this case, it is most preferable that the other has amino groups. In such a case, the molar ratio of amino to carboxyl is preferably from 0.1 to 10 moles of amino per mole of carboxyl. If the ratio is less than 0.1, the water developability of the water-developable photosensitive composition tends to be low. If the ratio exceeds 10, the post-photocure water resistance and ink resistance of the photosensitive composition may be drastically decreased. The more preferred molar ratio is from 0.4 to 2 moles of amino per mole of carboxyl.

In the water-developable photosensitive composition of the present invention, said crosslinking particulate resin (C) forms an ion pair with said hydrophilic polymer (B). Therefore, said hydrophilic polymer (B) is disposed around said crosslinking particulate resin (C) through such an ion pair. Therefore, when this water-developable photosensitive composition is manufactured into a flexographic printing plate, said hydrophilic polymer (B) is prevented from bleeding out from said crosslinking particulate resin (C) so that the performance characteristics, such as water developability, of the flexographic printing plate will not easily undergo aging.

The photopolymerization initiator (D) for use in the present invention is a component incorporated for starting the polymerization of photopolymerizable double bonds of said hydrophilic polymer (B) upon irradiation. The photopolymerization initiator (D) is not particularly restricted in kind but includes, among others, $\alpha$-diketones such as diacetyl, benzil, etc.; acyloins such as benzoin, pivaloin, etc.; acyloin ethers such as benzoin methyl ether, benzoin ethyl ether, benzoin isopropyl ether, etc.; polycyclic quinones such as anthraquinone, 2-ethylanthraquinone, 2-t-butylanthraquinone, 1,4-naphthoquinone, etc.; acetophenones such as 2,2-dimethoxyphenylacetophenone, 2,2-diethoxyacetophenone, trichloroacetophenone, etc.; benzophenones such as benzophenone, methyl o-benzoylbenzoate, Michler's ketone, etc.; mercaptans; and disulfides. Those initiators can be used alone or in combination.

As said photopolymerization initiator (D), commercial products can be also employed. For example, initiators in the Ingacure series (radical photopolymerization initiators, Ciba-Geigy (Japan), Ltd.) can be mentioned.

The preferred proportion of said photopolymerization initiator (D) is from 0.01 to 10 % by weight based on the total solid content of the water-developable photosensitive composition. If its amount is less than 0.01 %, the photocuring reactivity of the water-developable photosensitive composition tends to be insufficient. If the proportion of 10 % is exceeded, all of the photopolymerization initiator (D) will not take part in the photocuring reaction so that the practice is uneconomical. Moreover, because of its poor compatibility with said hydrophilic polymer (B), a uniform dispersion may not be obtained. The still more preferred range is from 0.05 to 5 % by weight.

The water-developable photosensitive composition of the present invention comprises said thermoplastic elastic polymer (A), said hydrophilic polymer (B), said crosslinking particulate resin (C) and said photopolymerization initiator (D), as mentioned above. If necessary, however, this water-developable photosensitive composition may be supplemented with various additives such as a polymerization inhibitor, a plasticizer, etc. in amounts not adversely affecting the performance of the composition.

The polymerization inhibitor is not particularly restricted in kind but includes hydroquinone, methylhydroquinone, methoxyphenol, N-nitrosodiphenylamine, etc.

The preferred proportion of said polymerization inhibitor is from 0.001 to 1 % by weight based on the total solid content of the water-developable photosensitive composition.

Said plasticizer is not restricted in kind, either, but includes dialkyl phthalates such as dibutyl phthalate, dihexyl phthalate, di-2-ethylhexyl phthalate, diheptyl phthalate, dioctyl phthalate, dinonyl phthalate, diisodecyl phthalate, etc.; dialkyl adipates such as di-2-ethylhexyl adipate, dioctyl adipate, diisodecyl adipate, etc.; trialkyl trimellitates such as trioctyl trimellitate, triisodecyl trimellitate, etc.; alkyl vinyl ethers such as octyl vinyl ether, lauryl vinyl ether, stearyl vinyl ether, etc.; poly(ethylene glycol) phenyl ether, poly(propylene glycol) phenyl ether, and so forth.

The preferred proportion of said plasticizer is from 0.01 to 20 % by weight based on the total solid content of the water-developable photosensitive composition. The more preferred proportion is from 0.05 to 10 % by weight.

For improving the postcure physical properties, particularly impact resilience, a commercial rubber emulsion may be added to the water-developable photosensitive composition of the present invention. The rubber emulsion is not particularly restricted in kind but preferably includes carboxylated nitrile-butadiene copolymer, carboxylated styrene-butadiene copolymer, and carboxylated chloroprene copolymer, etc. The mean particle diameter of those emulsions is preferably from 0.05 to 1 μm.

The proportion of said rubber emulsion is preferably from 0 to 20 % by weight based on the total solid content of the water to developable photosensitive composition. The still more preferred range is from 0 to 10 % by weight.

Where necessary, a photopolymerizable monomer may be added to the water-developable photosensitive composition. Generally, if such a photopolymerizable monomer is added to a water-developable photosensitive composition and a flexographic printing plate is manufactured from them and exposed to light, the unreacted photopolymerizable monomer interferes with enhancement of ink resistance. Therefore, it is preferable to avoid adding such a monomer. However, such a photopolymerizable monomer may be added within the range useful for increasing moderately the internal density of crosslinks of the water-developable photosensitive composition upon photocuring, as well as for contributing to the physical characteristics of the flexographic printing plate. When the photopolymerizable monomer is added to the water-developable photosensitive composition of the invention, a crosslinking agent is preferably added concomitantly.

Said photopolymerizable monomer is not particularly restricted in kind but includes those polymerizable monomers mentioned for the skeletal unit of said hydrophilic polymer (B).

The proportion of such a photopolymerizable monomer is preferably from 0 to 10 % by weight and more preferably from 0 to 5 % by weight based on the solid content of the water-developable photosensitive composition.

The water-developable photosensitive composition is preferably such that said thermoplastic elastic polymer (A) is incompatible with said hydrophilic polymer (B), said crosslinking particulate resin (C) and said photopolymerization initiator (D). In this case, the thermoplastic elastic polymer (A) forms a dispersed phase while the other components constitute a continuous phase.

The preferred particle diameter of said thermoplastic elastic polymer (A) forming said dispersed phase is from 0.01 to 50 μm. If the particle diameter is less than 0.01 μm, the fine particles may be distributed in an excessive density to reduce water developability. In addition, when the composition is processed into a flexographic printing plate, a sufficient degree of impact resilience may be failed to provide. A particle diameter in excess of 50 μm is also undesirable, for the resoltion of the flexographic printing plate may be adversely affected. The still more preferred particle diameter is from 0.05 to 10 μm.

The mean distance between adjacent dispersed domains in the dispersed phase, that is to say the mean dimension of the continuous phase interposed between adjacent particles of said thermoplastic elastic polymer (A), is preferably from 0.001 to 100 $\mu$m. If said distance or dimension is less than 0.001 $\mu$m, the water developability may be insufficient. If 100 $\mu$m is exceeded, the water-developable photosensitive composition may be excessively influenced by the continuous-phase components other than thermoplastic elastic polymer (A) so that, although satisfactory water developability may be assured, the impact resilience may be decreased and the hardness may be increased, thus making the composition unsuited for a flexographic printing plate. The still more preferred distance is from 0.05 to 5 $\mu$m.

The water-developable photosensitive composition of the present invention is advantageous in that while sufficient impact resilience can be provided by said thermoplastic elastic polymer (A), said crosslinking particulate resin (C) is conducive to improved water resistance without compromise in water developability of the flexographic printing plate. Moreover, since the composition does not contain a nongaseous ethylenically unsaturated compound, it is free of the problem associated with unreacted residues of such an ethylenically unsaturated compound (monomer) in the cured composition so that ink resistance is enhanced. Furthermore, said hydrophilic polymer (B) is bound to said crosslinking particulate resin through an ion pair, there is no bleeding problem, the shelf life of the composition itself is satisfactory, and a high degree of water developability is assured despite the low content of the hydrophilic component in the composition.

In addition, when the water-developable photosensitive composition comprises said dispersed phase and continuous phase, said hydrophilic polymer (B) and crosslinking particulate resin (C) forming said ion pair in the continuous phase provides an interpenetrating hydrophilic network so that an excellent degree of water developability is assured.

The method for producing a water-developable photosensitive composition according to the present invention comprises dispersing, in a solvent, (B) an ionic group- and photopolymerizable double bond-containing hydrophilic polymer, (C) a crosslinking particulate resin having an ionic pair capable of forming an ion pair with said polymer (B), and (D) a photopolymerization initiator, adding and dispersing (A) a thermoplastic elastic polymer therein, and then removing said solvent.

As said solvent, a solvent is used which does not dissolve said thermoplastic elastic polymer (A), said hydrophilic polymer (B) and said crosslinking particulate resin (C). Water or an aqueous mixture of an organic solvent is preferred in the method for producing a water-developable photosensitive composition according to the invention.

There is no particular limitation on the method for dispersing said hydrophilic polymer (B), said crosslinking particulate resin (C) and said photopolymerization initiator (D) in said solvent. Thus, according to the objective, the known dispersion technology using a pressure kneader, a planetary mixer, a two-roll mill, a three-roll mill, a hot roll mill, Disper, etc. can be selectively employed. The dispersing conditions can also be adequately selected according to the specific objective.

There is no particular limitation, either, on the method for adding and dispersing said thermoplastic elastic polymer (A) in a first dispersion of said hydrophilic polymer (B), crosslinking particulate resin (C) and initiator (D). To propmote mixing by lowering the softening point of said thermoplastic elastic polymer (A), the polymer (A) is preferably heated and melted before addition. An alternative preferred method comprises dissolving said thermoplastic elastic polymer (A) in an organic solvent and then adding the solution.

When the thermoplastic elastic polymer (A) is melted by heating prior to addition, the heating temperature is preferably from 100 to 200°C. By melting the thermoplastic elastic polymer (A) in this temperature range, it can be easily dispersed in a first dispersion of hydrophilic polymer (B), crosslinking particulate resin (C) and initiator (D).

When said thermoplastic elastic polymer (A) is dissolved in an organic solvent prior to addition, it can be easily dissolved by adding 1 to 1,000 parts by weight of an organic solvent to each 100 pats by weight of said thermoplastic elastic polymer (A). When the organic solvent is used in a proportion of not less than 300 parts by weight, the polymer can be easily dissolved at room temperature.

Said organic solvent is not particularly restricted in kind but includes benzene, toluene, xylene, chlorobenzene, dichlorobenzene, cyclohexane, n-hexane, and so on.

To provide for satisfactory aging resistance of a second dispersion prepared by adding said thermoplastic elastomeric polymer (A) to a first dispersion of said hydrophilic polymer (B), crosslinking resin (C) and initiator (D), the organic solvent is preferably removed, for example by distillation under reduced pressure, immediately following dispersion.

In the method for producing a water-developable photosensitive composition according to the present invention, an emulsifying dispersant can be added to a first dispersion of said hydrophilic polymer (B), crosslinking resin (C) and initiator (D) in order to facilitate dispersion of said thermoplastic elastic polymer (A).

As said emulsifying dispersant, any of an anionic surfactant, a nonionic surfactant, a cationic surfactant and an amphoteric surfactant can be employed, although an anionic surfactant or a nonionic surfactant is preferred. The more preferred one is an anionic surfactant. This anionic surfactant is expressed by the following general formula (I).

$$R^1\text{-}[(C_nH_{2n}O)_m]_k\text{-}A \qquad\qquad\qquad (I)$$

wherein R¹ represents the residue of a hydrogencontaining polar group having 8 to 22 carbon atoms; A represents an anion salt; n represents 2 or 3; m represents an integer of from 1 to 10; k represents 1 or 2.

In the above formula, R¹ includes but is not limited to the residues of primary alcohols such as 2-ethylhexanol, octanol, decanol, dodecanol, tetradecanol, hexadecanol, octadecanol, Alfol series, Dobanol series, benzyl alcohol, etc.; secondary alcohols such as Tergitol S, Softanol series, Oxocol series, etc.; phenols such as octylphenol, nonylphenol, etc.; thiols such as lauryl mercaptan, oleyl mercaptan, etc.; amines such as laurylamine, laurylmethylamine, dioleylamine, etc.; and carboxylic acids such as lauric acid, myristic acid, palmitic acid, oleic acid, stearic acid, behenic acid, etc.

The anion of said anion salt for A includes but is not limited to sulfonate ion, sulfate ion, phosphate ion and acetate ion. The cation pairing with said anion includes but is not limited to alkali metal ions such as lithium, sodium and potassium ions; ammonium ion of lower amine such as ammonia, methylamine, ethylamine, monoethanolamine, diethanolamine and triethanolamine ions. Alkali metal sulfonates, sulfate ester alkali metal salts, and alkali metal acetates are preferred among those anion salts.

Referring, further, to the above general formula (I), when A represents a sulfonate, a sulfate ester salt, or an acetate, k is equal to 1. When A is a phosphoric ester salt, k is equal to 1 or 2.

In the above formula, n represents the number of carbon atoms in the oxyalkylene unit. When both oxyethylene and oxypropylene units coexist, the respective units may occur at random or in blocks. The symbol m represents the degree of polymerization of said oxyalkylene unit, which is preferably from 2 to 4.

In the process for preparing the water-developable photosensitive composition according to the present invention, the anionic surfactant may be used in combination with a nonionic surfactant. The preferred nonionic surfactant is represented by the following general formula (II).

$$R^2\text{-}(C_pH_{2p}O)_q\text{-}H \hspace{3cm} \text{(II)}$$

wherein R² represents the residue of a hydrogencontaining polar group having from 8 to 22 carbon atoms; p represents 2 or 3; q represents an integer of from 0 to 20.

Referring to the above general formula, R² includes but is not limited to the species mentioned for R¹ above. The symbol p represents the number of carbon atoms in the oxyalkylene unit. When both oxyethylene and oxypropylene units coexist, the respective units may occur at random or in blocks. The symbol q represents the degree of polymerization of said oxyalkylene unit, which is preferably from 3 to 10.

Referring to the case in which said anionic surfactant is used in combination with said nonionic surfactant, the relative amount of the two surfactants is preferably within the range of (anionic surfactant/nonionic surfactant) = 100/0 to 10/90. If the proportion of said anionic surfactant is smaller than 10 % by weight, the emulsion stability of the aqueous emulsion will be adversely affected. The ratio is more preferably 100/0 to 20/80 and, for still better results, 100/0 to 40/60.

In the method for producing a water-developable photosensitive composition according to the present invention, there is no particular limitation on the method used for removing the solvent from the second dispersion after addition of said thermoplastic elastic polymer (A) to the first dispersion of said hydrophilic polymer (B), crosslinking resin (C) and initiator (D). Thus, any known technique and conditions can be selectively used according to the specific objective.

According to the method for producing a water-developable photosensitive composition according to the present invention, a water-developable photosensitive composition can be produced with good reproducibility, in which said thermoplastic elastic polymer (A) constitutes a dispersed phase and in which said hydrophilic polymer (B), crosslinking resin (C) and initiator (D) taken together constitute a continuous phase.

The water-developable photosensitive composition obtainable by the method of the present invention can be used in the field of ultraviolet-curable elastomers, specifically as the flexographic printing plate, photoresist, sand blast, adhesive, film, coating, and other products. The composition is particularly suited for use as a flexographic printing plate.

When the water-developable photosensitive composition of the present invention is to be used as a flexographic printing plate, the composition is bonded, by hot press, to the surface of a substrate such as iron sheet, aluminum sheet, or a plastic film, e.g. poly(ethylene terephthalate), polyester, polyethylene, polypropylene or other film, under heat and pressure in the same manner as the preparation of the conventional flexographic printing plate. If necessary, the reverse side of the substrate may also be provided with a film of the same plastic material as the substrate with or without formation of a thin coat or laminated layer of a material soluble in an aqueous developer, such as polyvinyl alcohol, polyacrylamide, hydroxypropylcellulose or the like.

Preparation of a printing from the above flexographic printing plate can be effected typically by superimposing a negative film having a transparent image pattern on said flexographic printing plate, irradiating the plate with ultraviolet light through said transparent film, and removing the unexposed background area with a developer. The irradiation with ultraviolet light can be carried out using a high-pressure mercury vapor lamp, a metal halide lamp, or the like as the light source. The preferred irradiation condition is from 500 to 5000 mJ/cm$^2$.

Said developer is not particularly restricted in kind only if it is a water-based developer. For example, tap water within the pH range of from 5.0 to 9.0 can be utilized. The tap water may contain alkaline compounds such as sodium hydroxide, sodium carbonate, etc., surfactants such as sodium alkylnaphthalenesulfonate, sodium alkylbenzenesulfonate, etc. and water-soluble organic solvents, among others. The developer is preferably used at from 25 to 45°C.

BEST MODE FOR CARRYING OUT THE INVENTION

The following examples are intended to illustrate the present invention in further detail and should by no means be construed as defining the scope of the invention.

Production Example 1

Production of an anionic group-containing crosslinking particulate resin

A reactor equipped with an agitation heater, thermometer, nitrogen gas inlet pipe and condenser tube was charged with 2 parts by weight of RA-1022 (an anionic reaction emulsifier, Nippon Emulsifier Co.) and 168 parts by weight of deionized water and was heated to 80°C . Thereto were concurrently added dropwise over 110 minutes 359.5 parts by weight of a monomeric mixture (preemulsion) of 18 parts by weight of RA-1022 (an anionic reaction emulsifier, Nippon Emulsifier Co.), 252 parts by weight of deionized water, 43.7 parts by weight of styrene, 41.3 parts by weight of n-butyl acrylate and 4.5 parts by weight of ethylene glycol dimethacrylate, and 56 parts by weight of an aqueous initiator solution composed of 0.5 part by weight of ammonium peroxydisulfate and 62 parts by weight of deionized water. The reaction was further continued for 60 minutes. Then, 10.5 parts by weight of a monomeric mixture of 10 parts by weight of acrylic acid and 0.5 part by weight of ethylene glycol dimethacrylate and the remainder (6.5 parts by weight) of said aqueous initiator solution were concurrently added dropwise over 10 minutes. The mixture was stirred for one hour to complete the reaction. The particle diameter of the crosslinking particulate resin emulsion thus obtained was 80 nm.

Production Example 2

Production of a cationic group-containing crosslinking particulate resin

A reactor equipped with an agitation heater, thermometer, nitrogen gas inlet pipe and condenser tube was charged with 2 parts by weight of RA-1022 (an anionic reaction emulsifier, Nippon Emulsifier Co.) and 168 parts by weight of deionized water and was heated to 80°C. Thereto were concurrently added dropwise over 110 minutes 347.5 parts by weight of a monomeric mixture (preemulsion) of 18 parts by weight of RA-1022 (an anionic reaction emulsifier, Nippon Emulsifier Co.), 252 parts by weight of deionized water, 53.5 parts by weight of styrene, 20 parts by weight of n-butyl acrylate and 4 parts by weight of ethylene glycol dimethacrylate, and 54 parts by weight of an aqueous initiator solution composed of 0.5 part by weight of potassium peroxydisulfate and 60 parts by weight of deionized water. The reaction was further continued for 60 minutes. Then, 22.5 parts by weight of a monomeric mixture of 21.5 parts by weight of N, N-dimethylamino-2-ethyl methacrylate and 1 part by weight of ethylene glycol dimethacrylate and the remainder (6.5 parts by weight ) of said aqueous initiator solution were concurrently added dropwise over 10 minutes. The mixture was stirred for one hour to complete the reaction. The particle diameter of the crosslinking particulate resin emulsion thus obtained was 80 nm.

Production Example 3

Production of a hydrophilic polymer

A reactor equipped with an agitation heater, thermometer, nitrogen gas inlet pipe and condenser tube was charged with 400 parts by weight of xylene and the temperature was increased to 110°C. Then, 110 parts by weight of a mixture of 37.1 parts by weight of RMA-150M (a water-soluble monomer, Nippon Emulsifier Co.), 52.9 parts by weight of styrene, 5 parts by weight of 2-hydroxyethyl methacrylate, 5 parts by weight of dimethylaminopropyl methacrylate and Kayaester O (t-butylperoxy-2-ethyl hexanoate, a polymerization initiator available from Kayaku-Akzo) was added dropwise over 60 minutes and the reaction was further continued for 120 minutes. The mixture was then cooled to 70°C and 6 parts by weight of 2-methacryloyloxyethyl isocyanate was added dropwise over 30 minutes. The mixture was further stirred for 2 hours to complete the reaction. The solvent was distilled off under reduced pressure to recover a viscous resin. The solid content of this resin was 90% and the number average molecular weight was 3,000.

Production Example 4

Production of a hydrophilic polymer

A reactor equipped with an agitation heater, thermometer, nitrogen gas inlet pipe and condenser tube was charged with 1,800 parts by weight of polybutadiene (Polyoil-110, HULS AG in German), 294 parts by weight of maleic anhydride, 18 parts by weight of xylene, 5.4 parts by weight of Sumilizer GM [2-t-butyl-6-(3'-t-butyl-5'-methyl-2'-hydroxybenzy)-4-methylphenyl acrylate, a rubber thermal aging inhibitor, Sumitomo Chemical], and 5.4 parts by weight of Sumilizer TP-D [pentaerythritol tetrakis( β -laurylpropionate), a rubber thermal aging inhibitor, Sumitomo Chemical], and the temperature was increased to 190°C. The reaction mixture was sampled at 1-hour intervals and the reaction was continued for 5 hours until the color reaction with dimethylaminobenzil became negative. Then, the reaction mixture was cooled to 140°C and 260 parts by weight of 2-hydroxyethyl methacrylate and 692 parts by weight of polyethylene glycol monomethyl ether (MPG-081, Nippon Emulsifier Co.) were added dropwise over 30 minutes. The reaction was further continued for 30 minutes, at the end of which time the reaction mixture was cooled. The solid content was 99% and the number average molecular weight was 2,100.

Example 1

To 800 parts by weight of toluene was added 200 parts by weight of KRATON D-1107 (polystyrene/polyisoprene/polystyrene triblock copolymer, a thermoplastic elastic polymer, Shell Chemical). The mixture was stirred to give a toluene solution of thermoplastic elastic polymer.

Then, using a Disper, 75 parts by weight of the anionic group-containing crosslinking particulate resin obtained in Production Example 1, 16.7 parts by weight of the hydrophilic polymer obtained in Production Example 4, 10 parts by weight of deionized water and 2.5 parts by weight of Irgacure-2959 [4-(2-hydroxyethyl)phenyl-(2-hydroxy-2-propyl) ketone, a radical photopolymerization initiator available from Ciba-Geigy (Japan), Ltd.] were stirred together to prepare an aqueous dispersion. To this aqueous dispersion was added 300 parts by weight of the above toluene solution of thermoplastic elastic polymer, and the mixture was further stirred with the Disper to provide an emulsion.

This emulsion was spread thin on a polypropylene sheet and dried in a vacuum dryer to provide a water-developable photosensitive composition. The drying condition was from 1 to 10 Torr, 40°C x 8 hours. The volatile fraction after drying was not greater than 3%.

The water-developable photosensitive composition thus obtained was extruded from a kneader-extruder equipped with a T die onto a polyester film precoated with a chloroprene adhesive (HIBON 1920LT, Hitachi Chemical Co., Ltd.) in a thickness of 5 μm to provide a water-developable printing plate having a photosensitive resin layer of about 1.7 mm in thickness.

The shelf life, impact resilience, hardness and water elution rate of the water-developable printing plate thus obtained were evaluated. The results are shown in Table 1.

Evaluation of shelf life

The water-developable printing plate was stored in a constant-temperature chamber at 20°C for 1 month. The impact resilience, hardness and water elution rate were measured before and after storage.

Measurement of impact resilience

Using a couple of 350 W UV lamps, the water-developable printing plate was irradiated with 1,500 mJ/cm$^2$ of ultraviolet radiation from both sides for 10 minutes and the photocured plate was cut into 2 cm-square pieces. Using a stack of 5 pieces, the coefficient of rebounce (%) was measured at 20°C using a falling-ball rebound tester.

Measurement of hardness

Using the same test sample as used in the above measurement of impact resilience, the Shore A hardness at 20°C was measured.

Measurement of water elution rate

Using a brush elution machine (JW-A2-PD, Nippon Electric Industry Co., Ltd.), the unexposed printing plate was eluted with water at 40°C for 3 minutes. The thickness was measured before and after storage to find the change in film thickness.

Example 2

Using a Disper, 100 parts by weight of the cationic group-containing crosslinking particulate resin obtained in Production Example 2, 22.2 parts by weight of the hydrophilic polymer obtained in Production Example 3, 10 parts by weight of deionized water and 2.5 parts by weight of Irgacure-2959 (a radical photopolymerization initiator available from Ciba-Geigy (Japan), Ltd.) were stirred together to give an aqueous dispersion. To this aqueous dispersion was added 250 parts by weight of a toluene solution of thermoplastic elastic polymer. The mixture was further stirred with the Disper to provide an emulsion.

This emulsion was spread thin on a polypropylene sheet and dried in a vacuum dryer to provide a water-developable photosensitive composition. The drying condition was from 1 to 10 Torr, 40°C x 8 hours. The volatile fraction after drying was not more than 1%.

Using this water-developable photosensitive composition, a water-developable printing plate was prepared as in Example 1.

The shelf life, impact resilience, hardness and water elution rate of the water-developable printing plate were evaluated as in Example 1. The results are presented in Table 1.

Comparative Example 1

Except that a solution of KRATON D-1107 in toluene was not added, the procedure of Example 1 was otherwise repeated to provide a photosensitive composition. Using this photosensitive composition, a printing plate was prepared as in Example 1.

The shelf life, impact resilience, hardness and water elution rate of this printing plate were evaluated as in Example 1. The results are shown in Table 1.

Comparative Example 2

To 80 parts by weight of toluene were added 200 parts by weight of KRATON D-1107 (polystyrene/polyisoprene/polystyrene triblock copolymer, a thermo-plastic elastomeric polymer available from Shell Chemical), and, as an ethylenically unsaturated monomer, 40 parts by weight of lauryl methacrylate. The mixture was stirred to give a toluene solution of thermoplastic elastomer solution.

Then, using a Disper, 75 parts by weight of the anionic group-containing crosslinking particulate resin obtained in Production Example 1, 16.7 parts by weight of the hydrophilic polymer obtained in Production Example 4, 10 parts by weight of deionized water and 2.5 parts by weight of Irgacure-2959 (a radical photopolymerization initiator available from Ciba-Geigy (Japan), Ltd.) were stirred together to give an aqueous dispersion. To this aqueous dispersion was added 300 parts by weight of the toluene solution of thermoplastic elastic polymer. The mixture was further stirred with a Disper to provide an emulsion.

Using the above emulsion, a printing plate was prepared as in Example 1.

The shelf life, impact resilience, hardness and water elution rate of this printing plate were evaluated as in Example 1. The results are presented in Table 1.

Comparative Example 3

Except that the anionic group-containing cross-linking particulate resin obtained in Production Example 1 was not added, the procedure of Example 1 was otherwise repeated to provide a photosensitive composition. Using this photosensitive composition, a printing plate was prepared as in Example 1.

The shelf life, impact resilience, hardness, and water elution rate of the above printing plate were evaluated as in Example 1. The results are presented in Table 1.

Table 1

| | Impact resilience (%) | | Hardness (degree) | | Water elution rate (mm/min) | |
|---|---|---|---|---|---|---|
| | Before storage | After storage | Before storage | After storage | Before storage | After Storage |
| Example 1 | 48 | 48 | 40 | 41 | 0.31 | 0.30 |
| Example 2 | 43 | 44 | 39 | 38 | 0.25 | 0.25 |

Table 1 (continued)

| | Impact resilience (%) | | Hardness (degree) | | Water elution rate (mm/min) | |
|---|---|---|---|---|---|---|
| | Before storage | After storage | Before storage | After storage | Before storage | After Storage |
| Comparative Example 1 | 13 | 13 | 58 | 59 | 0.43 | 0.32 |
| Comparative Example 2 | 42 | 42 | 50 | 58 | 0.25 | 0.10 |
| Comparative Example 3 | 38 | 37 | 38 | 43 | 0.15 | 0.00 |

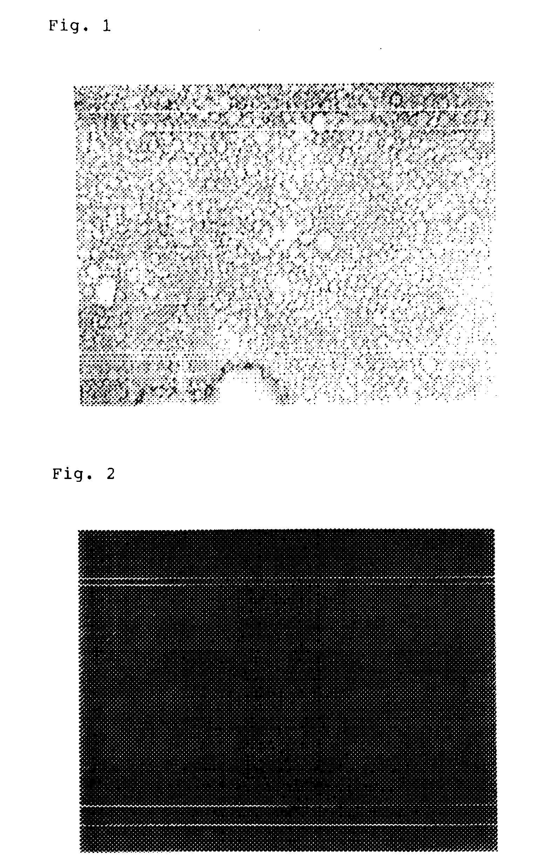

Using a press (100 atm), the water-developable photosensitive composition obtained in Example 1 was pressed into a 100 μm-thick film sheet. This sheet was immersed in a 1.0% aqueous solution of Primocyanine (crystal violet) for 5 minutes, then dried, and examined under the microscope at 1000 x magnification. The result is shown in Fig. 1. It is clear from Fig. 1 that the water-developable photosensitive composition according to Example 1 assumes a binary-phase structure in which the thermoplastic elastic polymer constitutes a dispersed phase with the remaining components forming a continuous phase.

Similar microscopic examinations were made for Example 2 and Comparative Examples 1 to 3. As to Example 2 and Comparative Examples 2 and 3, binary-phase structures similar to the structure obtained in Example 1 could be observed. However, in the case of Comparative Example 1 where the photosensitive composition did not contain a thermoplastic elastic polymer to constitute a dispersed phase, a binary phase structure could not be formed as can be seen in Fig. 2.

A negative film was placed in intimate contact with each of the water-developable photosensitive compositions obtained in Examples 1 and 2 and Comparative Examples 1 to 3. Using a high-pressure mercury vapor lamp (350 W), an exposure was made with 2,000 mJ/cm$^2$ of ultraviolet radiation for 10 minutes. After the negative film was removed, the composition was developed with deionized water (pH 7) at 45°C for 5 minutes to provide an image pattern. Using this image pattern, flexographic printing was carried out just after preparation of the image pattern and after 15 days. The condition and ink resistance of the print image were evaluated. The results are presented in Table 2.

Evaluation of print image

The print image obtained by flexographic printing was evaluated according to the following criteria.

○ : no unevenness of print image
Δ : slight unevenness of print image
✕ : unevenness of print image

Evaluation of ink resistance

Test printing with water-based ink (S,S Permanent Black, WERNEKE INK, U.S.A) was carried out. The dot gain/ink transfer characteristic (transferred ink concentration and ink skip) on printing paper around the 200,000th impression were evaluated on the following 3-grade scale.

○ : no change found even after 200,000 impressions
Δ : slight dot gain and ink skip
✕ : moderate dot gain and ink skip

Table 2

| | Evaluation of Print image | | Evaluation of ink resistance | |
|---|---|---|---|---|
| | Just after pattern preparation | After 15 days | Just after pattern preparation | After 15 days |
| Example 1 | ○ | ○ | ○ | ○ |

Table 2 (continued)

| | Evaluation of Print image | | Evaluation of ink resistance | |
|---|---|---|---|---|
| | Just after pattern preparation | After 15 days | Just after pattern preparation | After 15 days |
| Example 2 | ○ | ○ | ○ | ○ |
| Comparative Example 1 | × | × | × | × |
| Comparative Example 2 | ○ | Δ | Δ | Δ |
| Comparative Example 3 | Δ | × | Δ | Δ |

The water-developable photosensitive composition of the present invention, the constitution of which has been described in detail hereinbefore, has an excellent shelf life and can be used advantageously for flexographic printing plates. The flexographic printing plate obtained from the water-developable photosensitive composition of the present invention is very satisfactory in water resistance and ink resistance, which are generally considered to be conflicting properties, as well as in water-developability and impact resilience. It shows little aging, and is capable of yielding print images without unevenness.

The method for producing a water-developable photosensitive composition according to the present invention, which has been described in detail hereinbefore, is capable of providing the water-developable photosensitive composition of the invention with good reproducibility.

**Claims**

1. A water-developable photosensitive composition comprising (A) a thermoplastic elastic polymer, (B) an ionic group- and photopolymerizable double bond-containing hydrophilic polymer, (C) a crosslinking particulate resin having an ionic group capable of forming an ion pair with said polymer (B), and a photopolymerization initiator (D).

2. The water-developable photosensitive composition according to Claim 1, wherein said thermoplastic elastic polymer (A) is a triblock copolymer having a hard segment/soft segment/hard segment structure.

3. The water-developable photosensitive composition according to Claim 1 or 2, wherein the proportion of said thermoplastic elastic polymer (A) is from 40 to 90 % by weight based on the total weight of the composition.

4. The water-developable photosensitive composition according to Claim 1, 2 or 3, wherein said thermoplastic elastic polymer (A) is incompatible with said hydrophilic polymer (B), said crosslinking particulate resin (C) and said initiator (D);
said thermoplastic elastic polymer (A) forming a dispersed phase; and said hydrophilic polymer (B), said crosslinking particulate resin (C) and said initiator (D) taken together forming a continuous phase.

5. A process for producing the water-developable photosensitive composition according to Claim 1, 2, 3 or 4, which comprises dispersing, in a solvent, (B) an ionic group- and photopolymerizable double bond-containing hydrophilic polymer, (C) a crosslinking particulate resin having an ionic group capable of forming an ion pair with said polymer (B), and a photopolymerization initiator (D), adding and dispersing (A) a thermoplastic elastic polymer therein, and then removing said solvent.

6. The method for producing said water-developable photosensitive composition according to Claim 5, wherein said solvent is water or an aqueous mixture of an organic solvent.

7. Use of a water-developable photosensitive composition as claimed in any one of claims 1 to 4, for preparing a flexographic printing plate.

Fig. 1

Fig. 2

**EP 0 859 284 A1**

European Patent Office

**EUROPEAN SEARCH REPORT**

Application Number

EP 98 40 0325

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP 0 513 493 A (NIPPON PAINT CO LTD) 19 November 1992 | | G03F7/038 |
| A | US 5 422 225 A (SOUTHWICK JEFFREY G ET AL) 6 June 1995 | | |
| A | DATABASE WPI<br>Section Ch, Week 9707<br>Derwent Publications Ltd., London, GB;<br>Class A18, AN 97-074091<br>XP002065491<br>& JP 08 320 561 A (NIPPON PAINT CO LTD)<br>* abstract * | | |
| A | DATABASE WPI<br>Section Ch, Week 9404<br>Derwent Publications Ltd., London, GB;<br>Class A18, AN 94-028815<br>XP002065492<br>& JP 05 333 543 A (TORAY IND INC)<br>* abstract * | | |
| | | | TECHNICAL FIELDS SEARCHED (Int.Cl.6) |
| A | DATABASE WPI<br>Section Ch, Week 9529<br>Derwent Publications Ltd., London, GB;<br>Class A12, AN 95-221320<br>XP002065493<br>& JP 07 134 411 A (NIPPON GOSEI GOMU KK)<br>* abstract * | | G03F |
| A | DATABASE WPI<br>Section Ch, Week 9433<br>Derwent Publications Ltd., London, GB;<br>Class A89, AN 94-267057<br>XP002065494<br>& JP 06 194 837 A (NIPPON GOSEI GOMU KK)<br>* abstract * | | |

The present search report has been drawn up for all claims

| Place of search | Date of completion of the search | Examiner |
|---|---|---|
| THE HAGUE | 20 May 1998 | Philosoph, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)